# EUROPÄISCHE PATENTSCHRIFT

(11) **EP 1 454 344 B1**
(45) Veröffentlichungstag und Bekanntmachung des Hinweises auf die Patenterteilung: **14.03.2012**
(21) Anmeldenummer: 02779523.6
(22) Anmeldetag: 31.10.2002
(51) Int. Cl.: H01L 21/02

(54) **VERFAHREN ZUR HERSTELLUNG EINES INTEGRIERTEN HALBLEITERPRODUKTES MIT METALL-ISOLATOR-METALL-KONDENSATOR**
METHOD FOR FABRICATING AN INTEGRATED SEMICONDUCTOR PRODUCT COMPRISING A METAL-INSULATOR-METAL CAPACITOR
PROÉDÉ DE FABRICATION D'UN ÉLÉMENT INTÉGRÉ À SEMICONDUCTEURS COMPORTANT UN CONDENSATEUR MÉTAL-ISOLANT-MÉTAL

(30) Priorität: 13.12.2001 DE 10161285
(43) Veröffentlichungstag der Anmeldung: 08.09.2004
(73) Patentinhaber: Infineon Technologies AG, 85579 Neubiberg (DE)
(72) Erfinder: KÖRNER, Heinrich, 82052 Bruckmühl (DE); SCHRENK, Michael, 86911 Diessen am Ammersee (DE); SCHWERD, Markus, 32607 Holzkirchen (DE)
(74) Vertreter: Ginzel, Christian
(86) Internationale Anmeldenummer: PCT/EP2002/012213
(87) Internationale Veröffentlichungsnummer: WO 2003/054933

(56) Entgegenhaltungen:
- EP-A- 1 130 654
- US-B1- 6 271 084
- US-B1- 6 329 234
- LIU R ET AL: "SINGLE MASK METAL-INSULATOR-METAL (MIM) CAPACITOR WITH COPPER DAMASCENE METALLIZATION FOR SUB-0.18MUM MIXED MODE SIGNAL AND SYSTEM-ON-A-CHIP (SOC) APPLICATIONS" PROCEEDINGS OF THE IEEE, INTERNATIONAL INTERCONNECT TECHNOLOGY CONFERENCE, XX, XX, 5. Juni 2000 (2000-06-05), Seiten 111-113, XP001134903 in der Anmeldung erwähnt
- MAHNKOPF R ET AL: "'System on a chip' technology platform for 0.18 /spl mu/m digital, mixed signal and eDRAM applications" ELECTRON DEVICES MEETING, 1999. IEDM TECHNICAL DIGEST. INTERNATIONAL WASHINGTON, DC, USA 5-8 DEC. 1999, PISCATAWAY, NJ, USA,IEEE, US, 5. Dezember 1999 (1999-12-05), Seiten 849-852, XP010372100 ISBN: 0-7803-5410-9 in der Anmeldung erwähnt

## Beschreibung

Die vorliegende Erfindung betrifft ein Verfahren für ein integriertes Halbleiterprodukt mit Leiterbahnen und einem Metall-Isolator-Metall-Kondensator, insbesondere ein integriertes Halbleiterprodukt mit Leiterbahnen, die als wesentlichen Bestandteil Kupfer aufweisen.

Hochfrequenzschaltungen in BIPOLAR-, BICMOS- und CMOS-Technologie benötigen integrierte Kondensatoren mit hoher Spannungslinearität, genau einstellbaren Kapazitätswerten und vor allem niedrigen parasitären Kapazitäten. Die bisher eingesetzten konventionellen MOS- bzw. MIS-Kondensatoren weisen aufgrund spannungsinduzierter Raumladungszonen eine ungenügende Spannungslinearität auf. Der geringe Abstand zum Substrat bringt außerdem zahlreiche parasitäre Kapazitäten mit sich.

Diese Schwierigkeiten lassen sich durch den Einsatz sogenannter Metall-Isolator-Metall-Kondensatoren (MIM-Kondensatoren) umgehen, die üblicherweise zwischen zwei Metallisierungsebenen angeordnet sind und die somit einen deutlich größeren Abstand zum Substrat aufweisen. Dabei sollen diese Metall-Isolator-Metall-Kondensatoren möglichst ohne Veränderung und Beeinflussung der benachbarten Leiterbahnen in die vorhandenen Konzepte für eine Mehrlagenmetallisierung integriert werden.

Moderne Mehrlagenmetallisierungen werden bevorzugt mit dem "Damascene"-Verfahren hergestellt. Dabei werden die Strukturen für zukünftige Leiterbahnen oder Vias in das Intermetall-Dielektrikum geätzt. Daran anschließend werden diese Strukturen mit dem Leitbahnmaterial (z.B. Kupfer) gefüllt. Das auf der Oberfläche verbliebene Metall wird dann in einem abschließenden chemisch-mechanischen Polierschritt (CMP) wieder entfernt. Ein Vorteil der "Damascene"-Technik liegt darin, daß man sie auch bei sehr kleinen Strukturgrößen anwenden kann, bei denen das reaktive Ionenätzen (RIE) nicht mehr einsetzbar ist. Weiterhin ist die "Damascene"-Technik auch für alle Metalle geeignet, die wie z.B. Kupfer keine leichtflüchtigen Verbindungen bilden und daher nicht mittels RIE-Verfahren strukturiert werden können.

Bisherige Ansätze wie sie etwa aus der europäischen Patentanmeldung EP 1 130 654 A1 und den Artikeln "Single Mask MIM Capacitor with Cu Damascene Metallization for sub-0.18µm Mixed Mode Signal and System-on-a-Chip Applications", IEEE (2000) S. 111 ff. von Kiu et al. Und "System on a Chip Technology Platform for 0,18µm Digital, Mixed Signal & eDRAM Applications", Infineon Techn. Corp. and IBM Michroelectronics Div. von R. Mahnkopf et al. bekannt sind, verwenden die in der Mikroelektronik bekannten und gut charakterisierten Materialien Siliziumdioxid bzw. Silizium-Nitrid als Dielektrikum.

Jedoch liegen die Dielektrizitätskonstanten k dieser Materialien mit Werten von ca. vier bzw. sieben nicht sonderlich hoch. Weiterhin müssen sie wegen der Anwendung in der Mehrlagenmetallisierung in Plasma- (PECVD-) Verfahren abgeschieden werden. Diese Verfahren zeichnen sich typischerweise durch hohe Abscheideraten, aber auch durch hohe Defektdichten und mindere Schichtqualität aus. Daher lassen sich in Plasmaverfahren praktisch keine Schichten unter 60 nm mit reproduzierbarer Dicke und ausreichender Qualität herstellen.

Bei den oben zitierten Integrationskonzepten erfolgt außerdem die Strukturierung der Top-Elektrode mit Hilfe einer Top-Elektroden-Ätzung, die in dem Dielektrikum des Kondensators gestoppt werden muß. Aus diesem Grund erfordern diese Verfahren zwingend eine Dielektrikumsschicht mit einer ausreichenden Dicke von mindestens 60 nm.

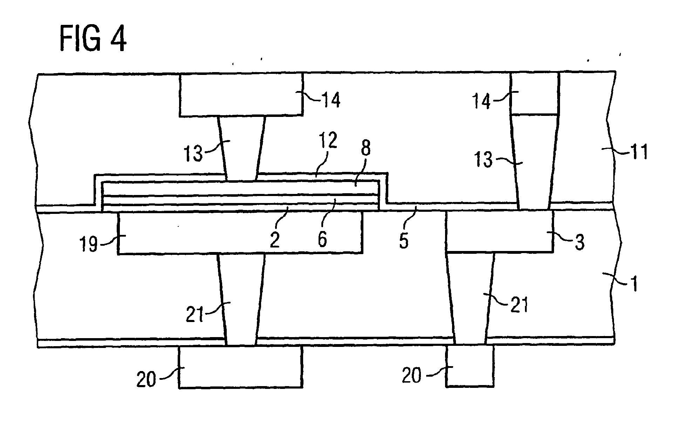

Figur 4 zeigt einen Ausschnitt aus einem Querschnitt durch ein integriertes Halbleiterprodukt mit einem MIM-Kondensator nach dem Stand der Technik. Dabei sind in einem unteren Intermetall-Dielektrikum 1 untere Leiterbahnen 20 mittels Vias 21 mit einer mittleren Ebene von Leiterbahnen 3, 19 verbunden. Die Leiterbahnen 3, 19, 20 und die Vias 21 sind mittels "Damascene"-Technik hergestellt.

Auf die planarisierte Oberfläche der mittleren Leiterbahnebene ist dann als untere Elektrode 2 des Kondensators eine 50 nm dicke Schicht aus TaN mittels PVD-Abscheidung aufgebracht. Darauf ist eine wiederum ca. 60 nm dicke Schicht als Kondensator-Dielektrikum 6 aufgebracht. Diese Schicht 6 kann z.B. aus SiO₂ bestehen, das mittels CVD aufgedampft wird. Darüber wird die zweite Elektrode 8 des Kondensators aufgebracht, die z.B. durch eine 50 nm dicke TaN Schicht gebildet sein kann.

Anschließend erfolgt die Strukturierung des zur Bildung des Kondensators vorgesehenen Schichtstapels, wobei der Ätzstop im Bereich des Kondensators (in der Figur links) auf dem Intermetall-Dielektrikum erfolgen muß, während der Ätzstop im Bereich der mittleren Leiterbahn 3 auf Kupfer erfolgt. Nach der Strukturierung wird eine Passivierungsschicht 12 aus Si₃N₄ abgeschieden. Die mittlere Leiterbahn 3 und die obere Elektrode 8 des Kondensators werden mittels Vias 13 kontaktiert. Diese Vias 13 sind in einem oberen Intermetall-Dielektrikum 11 ausgebildet und durch obere Leiterbahnen 14 abgeschlossen. Die so gebildete Oberfläche wird wiederum mittels CMP-Technik planarisiert.

Erhebliche prozeßtechnische Schwierigkeiten verursachen vor allem der notwendige Ätzstop auf Kupfer und die anschließende Lackentfernung bei freiliegendem Kupfer. Hier besteht die große Gefahr, daß die Qualität der Kupferbahn 3 beeinträchtigt wird. Eine weiteres Problem entsteht durch die vollständige Freiätzung des Kondensator-Stapels 2, 6, 8: Durch Unterätzung ergibt sich eine erhöhte Ausfallwahrscheinlichkeit durch mögliche Kurzschlüsse an den vertikalen Kanten.

Das Problem des Ätzstops auf Kupfer ist im Stand der technik bereits erkannt worden. Gemäß einer bereits bekannten Lösung wird vorgeschlagen, zusätzlich eine dünne Si₃N₄-Schicht direkt nach der Planarisierung der mittleren Leiterbahnebene 1, 3, 19 abzuscheiden. Anschließend wird die Si₃N₄-Schicht an der Stelle, an der der MIM-Kondensator vorgesehen ist, geöffnet. Der für diesen Schritt benötigte Fotolack wird bei offenliegender Kupferbahn 19 (Fig. 4 links) gestrippt.

Bei dem oben beschriebenen Verfahren stellt sich das prozeßtechnische Problem, daß bei der Öffnung der Si₃N₄-Schicht der Fotolack bei freiliegender Kupferbahn entfernt werden muß. Wegen der Oxidationsanfälligkeit von Kupfer ist daher mit einer Verschlechterung der Leiterbahnqualität zu rechnen. Außerdem ist gegenüber dem zuerst geschilderten Verfahren ein zusätzlicher Strukturierungsschritt und auch eine zusätzliche Fotomaske erforderlich, was wiederum den Aufwand und die Kosten für den Prozeßablauf deutlich erhöht.

Bei dem in EP 1 130 654 A1 beschriebenen integrierten Halbleiterprodukt wird die vorhandene Kupferbahn 19 als untere Elektrode 2 verwendet. Auf die mittels CMP-Technik planarisierte Oberfläche wird ein Schichtstapel aus Kondensator-Dielektrikum und dem Material für die obere Elektrode 8 abgeschieden. Anschließend wir dieser Stapel strukturiert, wobei der Ätzvorgang im Kondensator-Dielektrikum 6 stoppen muß.

Da bei diesem Verfahren der Ätzvorgang im Kondensator-Dielektrikum stoppen muß, bestehen strikte Einschränkungen bezüglich der Dicke und des Kondensator-Materials für das Dielektrikum 6. Da außerdem das Dielektrikum direkt auf die äußerst empfindliche Kupfer-Oberfläche abgeschieden wird, verbieten sich aufgrund der Oxidationsneigung von Kupfer Plasmaverfahren zur SiO₂-Abscheidung, die als einen Reaktionspartner Sauerstoff verwenden. Dadurch können SiO₂ und andere sauerstoffhaltige in diesem Verfahren nicht als Kondensator-Dielektrika verwendet werden.

Weiterhin liegt die flächenspezifische Kapazität solcher bekannter Kondensatoren um 1 fF/µm²; für zukünftige Hochfrequenzanwendungen ist jedoch ein Mehrfaches dieses Wertes erforderlich. Die flächenspezifische Kapazität eines Kondensators wird im wesentlichen durch die Dicke der dielektrischen Trennschicht und den Wert der Dielektrizitätskonstante bestimmt. Eine Erhöhung der flächenspezifischen Kapazität eines Kondensators kann deshalb durch die Verwendung von Dielektrika mit einer hohen Dielektrizitätskonstante (>8) erreicht werden. Weiterhin führen auch Isolationsschichten, die dünner als 60 nm sind, zu einer Erhöhung der flächenspezifischen Kapazität. Weitere Verfahren zur Herstellung von M/M-Kondensatoren sind aus den Scheiften US-6,271,084 und US-6,329,234 bekannt.

Ausgehend vom beschriebenen Stand der Technik liegt der Erfindung die Aufgabe zugrunde, ein verbessertes integriertes Halbleiterprodukt mit Leiterbahnen und einem Metall-Isolator-Metall-Kondensator zu schaffen und ein Verfahren zu dessen Herstellung anzugeben.

Diese Aufgabe wird durch ein Verfahren nach Anspruch 1 gelöst. Weitere vorteilhafte Ausgestaltungen und Aspekte der Erfindung sind in den abhängigen Ansprüchen, der Beschreibung sowie in den beiliegenden Figuren angegeben.

Erfindungsgemäß wird ein integriertes Halbleiterprodukt mit Leiterbahnen, welche als wesentlichen Bestandteil Kupfer aufweisen, bereitgestellt, das zumindest einen Metall-Isolator-Metall-Kondensator aufweist, der eine erste Elektrode, eine dielektrische Schicht und eine zweite Elektrode umfaßt. Die dielektrische Schicht ist dabei in einer über der ersten Elektrode angeordneten Öffnung einer dielektrischen Hilfsschicht angeordnet.

Weiterhin wird ein Verfahren zur Herstellung eines integrierten Halbleiterprodukts mit Leiterbahnen, welche als wesentlichen Bestandteil, Kupfer aufweisen, und zumindest einem Metall-Isolator-Metall-Kondensator, der eine erste Elektrode, eine dielektrische Schicht und eine zweite Elektrode umfaßt, bereitgestellt. Das Verfahren umfaßt die folgenden Schritte:
(a) die erste Elektrode wird in einer Schicht erzeugt, die auch als Schicht für Leiterbahnen vorgesehen ist;
(b) eine dielektrische Schutzschicht wird aufgebracht;
(c) eine dielektrische Hilfsschicht wird aufgebracht;
(d) die dielektrische Schutzschicht und die dielektrische Hilfsschicht werden über der ersten Elektrode geöffnet;
(e) die dielektrische Schicht für den Kondensator wird erzeugt;
(f) die zweite Elektrode wird erzeugt.

Das hier vorgestellte Konzept eignet sich insbesondere, aber nicht ausschließlich, zur Integration von MIM-Kondensatoren mit dünnen Dielektrika ohne die Zuverlässigkeit der übrigen Metallbahnen signifikant zu verändern. Die Zuverlässigkeit der übrigen Metallbahnen bleibt im wesentlichen unverändert, da insbesondere keine Reste der dielektrischen Kondensatorschicht auf den übrigen Metallbahnen vorhanden ist. Außerdem ist das Verfahren gemäß der vorliegenden Erfindung bezüglich der einzelnen Prozeßschritte relativ unkritisch zu realisieren und erlaubt größere Freiheiten in der Auswahl von Materialien und deren Dicke. Insbesondere besitzt das Verfahren gemäß der vorliegenden Erfindung den Vorteil, daß Via-Ätzungen deutlich einfacher als nach dem Stand der Technik durchgeführt werden können, da kein Durchätzen der restlichen, dielektrischen Kondensatorschicht über den Metallbahnen notwendig ist.

Der Metall-Isolator-Metall-Kondensator weist eine erste Elektrode auf, die in einer Metallebene für Leiterbahnen ausgebildet ist. Da die dielektrische Zwischenschicht und die Metallisierungsschicht für die zweite Elektrode dünn gehalten werden kann, kann der Metall-Isolator-Metall-Kondensator ohne große Schwierigkeiten in ein bestehendes Konzept zur Herstellung eines integrierten Halbleiterprodukts mittels "Damascene"-Technik integriert werden.

Zweckmäßigerweise wird der Metall-Isolator-Metall-Kondensator dadurch hergestellt, daß auf ein Substrat eine Metallschicht für Leiterbahnen aufgebracht wird. Nachfolgend wird auf die Metallschicht für Leiterbahnen eine dielektrische Schutzschicht und eine dielektrische Hilfsschicht abgeschieden. Die dielektrische Hilfsschicht dient als partielle Opferschicht und spielt nicht die Rolle des MIM-Dielektrikums, sondern wird Teil des später aufgebrachten Intermetall-Dielektrikums (IMD). Mit den bekannten Methoden der Lithographie und Ätztechnik werden die dielektrische Schutzschicht und die dielektrische Hilfsschicht an jenen Stellen, an denen die Integration eines MIM-Kondensators vorgesehen ist, entfernt. Vorzugsweise wird der zum Öffnen der beiden Schichten benötigte Fotolack bereits verascht, wenn die Schutzschicht noch nicht entfernt wurde. Dabei ist es insbesondere bevorzugt, wenn eine entsprechende Ätzung selektiv auf der unteren Elektrode stoppt. Auf die entsprechend strukturierte Oberfläche wird eine Dielektrikumsschicht aus frei wählbarem Material und beliebiger Dicke abgeschieden. Nachfolgend werden die Materialien, die die zweite Elektrode bilden, aufgebracht und entsprechend strukturiert.

Damit ist die Möglichkeit eröffnet, eine extrem dünne dielektrische Schicht per ALD (atomic layer deposition) atomlagenweise abzuscheiden. Da dabei keinerlei Plasmaanregung verwendet wird, steht mit der ALD anstelle von PECVD ein weiteres alternatives Verfahren zur Abscheidung von oxidischen oder sauerstoffhaltigen Schichten zur Verfügung, ohne die Kupfer-Oberfläche zu beschädigen.

Gemäß einer weiteren bevorzugten Ausführungsform des erfindungsgemäßen Verfahrens wird vor Schritt (e) auf die erste Elektrode eine leitende Barriere aufgebracht. Dabei ist es insbesondere bevorzugt, wenn die leitende Barriere selektiv nur auf die freiliegende erste Elektrode aufgebracht wird.

Nachfolgend wird ein Ausführungsbeispiel der Erfindung anhand der beigefügten Zeichnungen erläutert. Es zeigen:

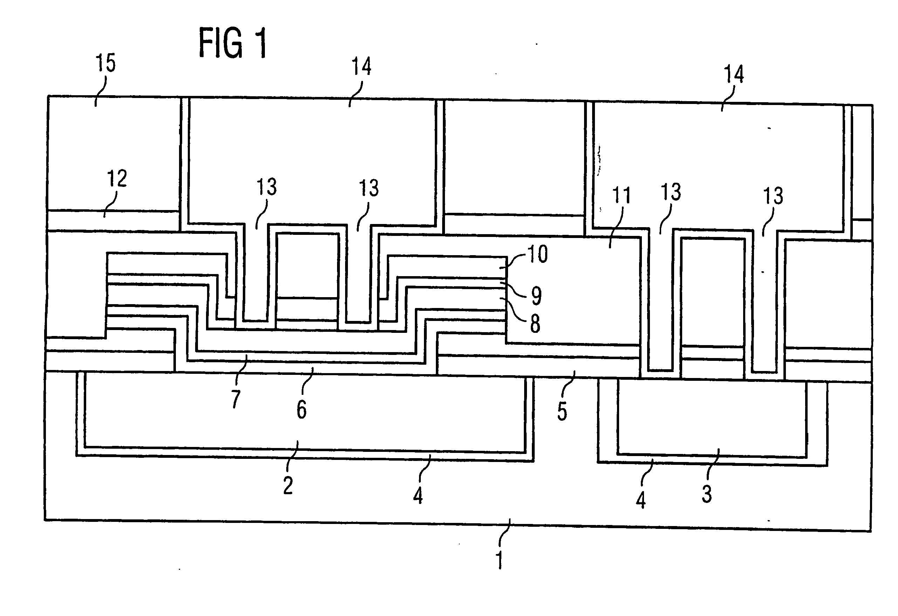

- Figur 1: einen Ausschnit aus einem Querschnitt durch ein integriertes Halbleiterprodukt, das einen Metall-Isolator-Metall-Kondensator enthält, gemäß einem Ausführungsbeispiel der Erfindung.
- Figur 2: einen Ausschnitt aus einem Querschnitt durch ein integriertes Halbleiterprodukt gemäß einem Ausführungsbeispiel der vorliegenden Erfindung in einem ersten Prozeßstadium, wobei eine dielektrische Hilfsschicht bereits über der ersten Elektrode geöffnet ist.
- Figur 3: einen Ausschnitt aus einem Querschnitt durch ein integriertes Halbleiterprodukt gemäß einem Ausführungsbeispiel der vorliegenden Erfindung in einem zweiten Prozeßstadium, wobei der Kondensatorstapel bereits strukturiert worden ist.
- Figur 4: einen Ausschnitt aus einem Querschnitt durch einen MIM-Kondensator in "Damascene"-Technik gemäß dem Stand der Technik.

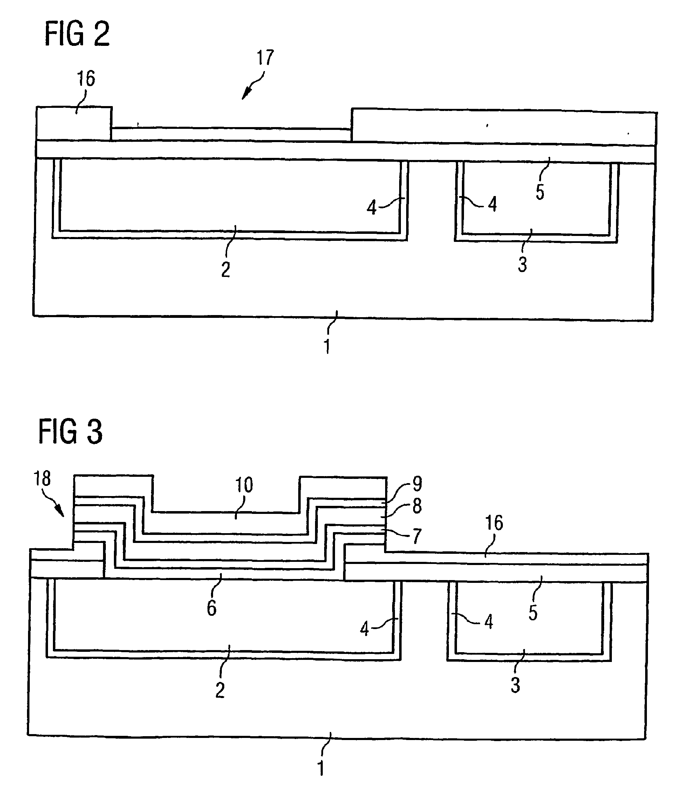

Figur 2 zeigt eine Metallbahn in "Damascene"-Architektur mit einer Leiterbahn 3 aus Cu wie sie auch im entsprechenden Stand der Technik verwendet wird. Dabei soll die Leiterbahn 2 auch als untere MIM-Elektrode fungieren. Auf die Metallbahn wird eine dielektrische Schutzschicht 5 aus Si₃N₄ abgeschieden. Auf diese Schutzschicht wird dann anschließend eine dielektrische Hilfsschicht 16 aus SiO₂ von ca. 50-100 nm Dicke mit bekannten, metallisierungskompatiblen Verfahren abgeschieden. Sie dient als partielle Opferschicht und spielt nicht die Rolle eines MIM-Dielektrikums sondern wird Teil des später aufgebrachten Intermetall-Dielektrikums (IMD). Mit den bekannten Methoden der Lithographie und Ätztechnik wird die dielektrische Hilfsschicht an der Stelle 17, an der die Integration eines MIM-Kondensators vorgesehen ist, entfernt. Nach dem Entfernen der Hilfsschicht 16 wird der zur Strukturierung der Öffnung verwendete Fotolack verascht. Dabei ist die erste Elektrode 2 durch die Schutzschicht 5 während des Veraschens geschützt. Eine weitere Leiterbahn 3 ist während des Veraschens sowohl durch die verbliebene Hilfsschicht 16 wie auch durch die Schutzschicht 5 geschützt. Anschließend wird ein eventuell in der Öffnung verbliebener Rest der SiO₂-Hilfsschicht und die Schutzschicht 5 entfernt. Dabei dient die partiell entfernte Hilfsschicht 16 als Hartmaske für die Öffnung.

Figur 3 zeigt den MIM-Kondensator nach erfolgter Abscheidung und Strukturierung des MIM-Dielektrikums 6, der oberen Elektrode 7, 8, 9 und einer Passivierungsschicht 10. Nach dem Öffnen der dielektrischen Hilfsschicht 16 und der Schutzschicht 5 wird nun eine dielektrische Schicht 6 beispielsweise aus Al₂O₃ mit einer Dicke von 20 nm erzeugt. Dies ist jedoch nicht zwingend, da das Dielektrikum 6 frei wählbar ist und in beliebiger Dicke abgeschieden werden kann. Vor der Abscheidung des Dielektrikums kann weiterhin eine leitende Barriere (nicht gezeigt), beispielsweise TaN, auf die ersten Elektrode aufgebracht werden. Dabei ist es insbesondere bevorzugt, wenn die leitende Barriere selektiv nur auf die freiliegende erste Elektrode aufgebracht wird.

Da ein Integrationsweg gemäß diesem Ausführungsbeispiel keine Mindestanforderungen an Dicke, Ätzverhalten und andere Eigenschaften der dielektrischen Schicht 6 stellt, sind beliebige Verfahren zu ihrer Erzeugung einsetzbar wie CVD, PECVD, MOCVD, und PVD, solange die Schichten bei Temperaturen unter 400°C erzeugt werden können. Die dielektrische Schicht 6 kann auch mit Hilfe einer Oxidation der Oberfläche der unteren Elektrode oder mit Hilfe der Oxidation einer dafür vorgesehenen Schicht (z.B. Ta und/oder TaN) auf der unteren Elektrode erzeugt werden. Weiterhin ist die Möglichkeit eröffnet, die dielektrische Schicht 6 per ALD (atomic layer deposition) abzuscheiden. Dieses Verfahren erlaubt es, mittels atomlagenweiser Abscheidung extrem dünne Schichten herzustellen. Das erfindungsgemäße Verfahren eröffnet den Zugang zu Kondensatoren mit spezifischen Kapazitäten von 3 fF/pm² bis deutlich über 10 fF/pm², die mit den bisherigen Ansätzen nicht mit ausreichender Qualität reproduzierbar hergestellt werden konnten.

Durch Abscheidung mittles ALD wird ein alternatives Verfahren zur PECVD zur Verfügung gestellt, das es erlaubt, oxidische oder sauerstoffhaltige Schichten abzuscheiden. Da die ALD keinerlei Plasmaanregungen verwendet, wird die empfindlichen Kupfer-Oberfläche der ersten Elektrode und damit die Qualität des Kondensators nicht degradiert.

Nachfolgend werden die Materialien für die obere Elektrode aufgebracht. Diese umfassen leitende Barrieren 7, 9, die beispielweise TiN beinhalten können. Dazwischen ist eine metallische Schicht 8 angeordnet, die beispielsweise AlCu beinhalten kann. Die durch die vorausgegangene Öffnung 17 der dielektrischen Hilfsschicht 16 erzeugte Topologie ist relativ gering: Die Kantenlänge der unteren Elektroden ist größer 1 µm und die Stufenhöhe beträgt ca. 50 -100 nm. Die Topologie kann daher von den gewählten Abscheideverfahren gut bedeckt werden. Auf die obere leitende Barriere 9 wird noch eine Passivierungsschicht 10 aus Si₃N₄ abgeschieden.

Anschließend erfolgt die Ätzung des Stapels aus der Passivierungsschicht 10, der oberen Elektrode 7, 8, 9, der dielektrischen Schicht 6 und der Hilfsschicht 16. Dabei sind an die auf der Schutzschicht 5 verbleibende Restdicke der dielektrischen Hilfsschicht 16 und damit an die Selektivität des Ätzprozesses keine besonderen Anforderungen gestellt. Dadurch entsteht im Gegensatz zu den beschriebenen und dazu ähnlichen Konzepten ein sehr großes Prozeßfenster für die gesamte Vorgehensweise bei gleichzeitiger freier Wahl des Dielektrikums 6 und seiner Dicke.

Darauffolgend wird ein oberes Intermetall-Dielektrikum 11 abgeschieden. Etwaige Reste der dielektrischen Hilfsschicht 16 werden nun einfach ein Teil dieses IMDs 11. Zur Kontaktierung des Kondensators und der unteren Leiterbahn 3 werden Vias 13 ausgebildet, die an ihrem oberen Ende mit oberen Leiterbahnen 13 verbunden sind. Diese oberen Leiterbahnen 14 sind wiederum in ein Intermetall-Dielektrikum 15 eingebettet. Dabei können die Via-Ätzungen deutlich einfacher als nach dem Stand der Technik durchgeführt werden, da kein Durchätzen der restlichen, dielektrischen Kondensatorschicht über den Metallbahnen notwendig ist.

Alle Leiterbahnen und Vias sind in diesem Ausführungsbeispiel mittels der "Damascene"-Technik ausgebildet.

Die im obigen Ausführungsbeispiel beschriebenen Metallisierungs- und Plattenkondensator-Materialien sind beispielhaft und nicht auf diese beschränkt. Insbesondere sind alle leitenden Materialien wie Si, W, Cu, Ag, Au, Ti, Pt und Legierungen davon als Leiterbahnen einsetzbar. Als alternative Barrieren bzw. Linerschichten eignen sich neben Ti und TiN insbesondere auch TiW, W, WNₓ mit 0≤x≤2, Ta, TaN, Silizide und Karbide. Als Elektroden lassen sich alle genannten Materialien und deren Kombinationen verwenden. Neben den klassischen Dielektrika der Halbleitertechnologie Si0₂ und Si₃N₄ steht die gesamte Palette an Materialien mit deutlich höherem k zur Verfügung, insbesondere Al₂O₃, Zr0₂, Hf0₂, Ta₂O₅, La₂O₃, Ti0₂ sowie die jeweiligen Mischoxide, Oxinitride und Silikate hieraus, SrTiO₃, BaₓSr₁₋ₓTiO₃ mit 0≤x≤1 (BST) und PbZrₓTi₁₋ₓO₃ mit 0≤x≤1 (PZT).

## Patentansprüche

1. Verfahren zur Herstellung eines integrierten Halbleiterprodukts mit Leiterbahnen, welche als wesentlichen Bestandteil Kupfer aufweisen, und zumindest einem Metall-Isolator-Metall-Kondensator, der eine erste Elektrode (2), eine dielektrische Schicht (6) und eine zweite Elektrode (7, 8, 9) umfaßt, mit folgenden Schritten:
(a) die erste-Elektrode wird in einer Schicht erzeugt, die auch als Schicht für Leiterbahnen vorgesehen ist;
(b) eine dielektrische Schutzschicht (5) wird aufgebracht;
(c) eine dielektrische Hilfsschicht (16) wird aufgebracht;
(d) die dielektrische Schutzschicht (5) und die darüber liegende dielektrische Hilfsschicht (16) werden über der ersten Elektrode geöffnet;
(e) die dielektrische Schicht (6) für den Kondensator wird erzeugt;
(f) die zweite Elektrode (7, 8, 9) wird erzeugt, wobei ein Stapel aus einer Passivierungsschicht (10), den darunter aufgebrachten Materialien der zweiten Elektrode (7, 8, 9), der dielektrischen Schicht (6) und der dielektrischen Hilfsschicht (16) bis in die dielektrische Hilfsschicht (16) geätzt wird; und danach
(g) ein oberes Intermetall-Dielektrikum (11) so auf die verbleibende Hilfsschicht (16) und die Passivierungsschicht (10) abgeschieden wird, dass Reste der dielektrischen Hilfsschicht (16) einen Teil eines Intermetall-Dielektrikums (16, 11) bilden.

2. Verfahren nach Anspruch 1,
**dadurch gekennzeichnet, daß**
der zur Strukturierung der Öffnung (17) verwendete Fotolack bereits verascht wird, wenn die erste Elektrode noch von der dielektrischen Schutzschicht bedeckt ist.

3. Verfahren nach Anspruch 1 oder 2,
**dadurch gekennzeichnet, daß**
für die zweite Elektrode zwei leitende Barrieren (7, 9) und eine dazwischen angeordnete Metallschicht (8) aufgebracht werden.

4. Verfahren nach einem der Ansprüche 1 bis 3,
**dadurch gekennzeichnet, daß**
zur Erzeugung der dielektrischen Schicht (6) eines der folgenden Verfahren verwendet wird: CVD, PECVD, MOCVD, PVD, ALD.

5. Verfahren nach einem der Ansprüche 1 bis 4,
**dadurch gekennzeichnet, daß**
zur Erzeugung der dielektrischen Schicht (6) die Oberfläche der ersten Elektrode oder eine Schicht auf der ersten Elektrode oxidiert wird.

6. Verfahren nach einem der Ansprüche 1 bis 5,
**dadurch gekennzeichnet, daß**
zumindest eine obere Leiterbahn (14) über zumindest einen Via (13) mit dem Kondensator verbunden wird.

7. Verfahren nach einem der Ansprüche 1 bis 6,
**dadurch gekennzeichnet, daß**
die erste Elektrode (2) in einem Damascene-Verfahren hergestellt wird.

8. Verfahren nach einem der Ansprüche 1 bis 7,
**dadurch gekennzeichnet, daß**
vor Schritt (e) auf die erste Elektrode eine leitende Barriere aufgebracht wird.

9. Verfahren nach Anspruch 8,
**dadurch gekennzeichnet, daß**
vor Schritt (e) auf die erste Elektrode eine leitende Barriere selektiv aufgebracht wird.

## Claims

1. Method for fabricating an integrated semiconductor product with interconnects, which include copper as an essential constituent, and at least one metal-insulator-metal capacitor, which comprises a first electrode (2), a dielectric layer (6) and a second electrode (7, 8, 9), involving the following steps:
(a) the first electrode is produced in a layer which is also intended as a layer for interconnects;
(b) a dielectric protective layer (5) is applied;
(c) a dielectric auxiliary layer (16) is applied;
(d) the dielectric protective layer (5) and the overlying dielectric auxiliary layer (16) are opened above the first electrode;
(e) the dielectric layer (6) for the capacitor is produced;
(f) the second electrode (7, 8, 9) is produced, during which step a stack comprising a passivation layer (10), the subjacent materials of the second electrode (7, 8, 9), the dielectric layer (6) and the dielectric auxiliary layer (16) is etched down into the dielectric auxiliary layer (16); and then
(g) an upper intermetal dielectric (11) is deposited on the remaining auxiliary layer (16) and the passivation layer (10) in such a way that residues of the dielectric auxiliary layer (16) form part of an intermetal dielectric (16, 11).

2. Method according to Claim 1, **characterized in that** the photoresist which is used to pattern the opening (17) has already been incinerated before the first electrode is covered by the dielectric protective layer.

3. Method according to Claim 1 or 2, **characterized in that** two conductive barriers (7, 9) and a metal layer (8) arranged between them are applied for the second electrode.

4. Method according to one of Claims 1 to 3, **characterized in that** one of the following processes is used to produce the dielectric layer (6): CVD, PECVD, MOCVD, PVD, ALD.

5. Method according to one of Claims 1 to 4, **characterized in that** the surface of the first electrode or a layer on the first electrode is oxidized in order to produce the dielectric layer (6).

6. Method according to one of Claims 1 to 5, **characterized in that** at least one upper interconnect (14) is connected to the capacitor through at least one via (13).

7. Method according to one of Claims 1 to 6, **characterized in that** the first electrode (2) is produced using a Damascene process.

8. Method according to one of Claims 1 to 7, **characterized in that** a conductive barrier is applied to the first electrode before step (e).

9. Method according to Claim 8, **characterized in that** a conductive barrier is applied selectively to the first electrode before step (e).

## Revendications

1. Procédé de fabrication d'un élément intégré à semiconducteurs ayant des pistes conductrices qui comportent du cuivre comme constituant essentiel et au moins un condensateur métal-isolant-métal qui comprend une première électrode (2), une couche (6) diélectrique et une deuxième électrode (7, 8, 9) ayant les stades suivantes :
(a) on produit la première électrode dans une couche qui est prévue aussi comme couche pour des pistes conductrices ;
(b) on dépose une couche (5) diélectrique de protection ;
(c) on dépose une couche (16) diélectrique ;
(d) on ouvre au dessus de la première électrode la couche (5) diélectrique de protection et la couche (16) diélectrique auxiliaire se trouvant dessus ;
(e) on produit la couche (6) pour le condensateur ;
(f) on produit la deuxième électrode (7, 8, 9) en attaquant, jusque dans la couche (16) diélectrique auxiliaire, un empilement composé d'une couche (10) de passivation, des matériaux, déposés dessous, de la deuxième électrode (7, 8, 9), de la couche (6) diélectrique et de la couche (16) diélectrique auxiliaire ; et ensuite
(g) on dépose un diélectrique (11) intermétallique supérieur sur la couche (16) auxiliaire restante et sur la couche (10) de passivation de manière à ce que des restes de la couche (16) diélectrique auxiliaire forment une partie d'un diélectrique (16, 11) intermétallique.

2. Procédé suivant la revendication 1,
**caractérisé en ce que** le vernis photosensible utilisé pour la structuration de l'ouverture (17) est déjà réduite en cendres lorsque la première électrode est recouverte encore de la couche diélectrique de protection.

3. Procédé suivant la revendication 1 ou 2,
**caractérisé en ce que** l'on dépose pour la deuxième électrode deux barrières (7, 9) conductrices et une couche (8) métallique disposée entre elles.

4. Procédé suivant l'une des revendications 1 à 3,
**caractérisé en ce que**, pour la production de la couche (6) diélectrique, on utilise l'un des procédés suivants . CVD, PECVD, MOCVD, PVD, ALD.

5. Procédé suivant l'une des revendications 1 à 4,
**caractérisé en ce que**, pour la production de la couche (6) diélectrique, on oxyde la surface de la première électrode ou une couche sur la première électrode.

6. Procédé suivant l'une des revendications 1 à 5,
**caractérisé en ce que** on relie au moins une piste (14) conductrice supérieure au condensateur par au moins une traversée (13).

7. Procédé suivant l'une des revendications 1 à 6,
**caractérisé en ce que** l'on produit la première électrode (2) suivant un procédé damascène.

8. Procédé suivant l'une des revendications 1 à 7,
**caractérisé en ce que**, avant le stade (e), on dépose une barrière conductrice sur la première électrode.

9. Procédé suivant la revendication 8,
**caractérisé en ce que** avant le stade (e), on dépose sélectivement une barrière conductrice sur la première électrode.
